Europäisches Patentamt

European Patent Office

Office européen des brevets

(11) Numéro de publication: **0 007 267**
**A1**

## DEMANDE DE BREVET EUROPEEN

(21) Numéro de dépôt: **79400428.3**

(22) Date de dépôt: **27.06.79**

(51) Int. Cl.³: **G 01 D 5/34**
**H 03 K 13/18**

(30) Priorité: **06.07.78 FR 7820145**

(43) Date de publication de la demande:
**23.01.80 Bulletin 80/2**

(84) Etats Contractants Désignés:
**DE GB IT**

(71) Demandeur: **DUCELLIER & Cie**
**Echat 950**
**F-94024 Creteil Cedex(FR)**

(72) Inventeur: **Marchal, Michel**
**25 Rue Ronsard**
**F-91470 Limours(FR)**

(74) Mandataire: **Habert, Roger**
**DUCELLIER & Cie Echat 950**
**F-94024 Creteil Cedex(FR)**

(54) **Capteur optoélectronique de déplacement longitudinal.**

(57) Capteur optoélectronique de déplacement longitudinal, caractérisé en ce qu'il comporte des moyens de filtrage et de protection contre les surtensions ; des moyens d'émission 100 et de réception 200 de rayons infrarouges ; un moyen d'occultation 300 de l'émission de rayons infrarouges ; des moyens de codage 400 en code binaire réfléchi des signaux issus des moyens de réception des rayons infrarouges ; des moyens de transformation 500 des signaux codes en code binaire réfléchi de manière qu'en sortie du capteur on dispose d'un nombre binaire ordinaire représentatif de la grandeur variable du déplacement.

_FIG. 1_

## Capteur optoélectronique de déplacement longitudinal

L'invention concerne un capteur optoélectronique de déplacement longitudinal permettant de convertir la grandeur variable d'un déplacement longitudinal en un nombre binaire représentatif de ladite grandeur.

Les progrès de l'électronique permettent d'envisager la conception de dispositifs électroniques dans lesquels diverses informations telles, par exemple, que le débit de l'air, la teneur en oxygène d'un mélange gazeux, les variations de température de fonctionnement etc... seront adressées à un calculateur numérique tel, par exemple, qu'un calculateur pour un dispositif électronique d'allumage d'un moteur à combustion interne, notamment pour véhicules automobiles.

La connaissance des données ci-dessus mentionnées nécessite la conception et la réalisation de capteurs divers.

L'objet de la présente invention est de procurer un capteur optoélectronique du déplacement d'un élément dont la grandeur variable du déplacement, entre deux limites, est fonction des variations du paramètre à capter.

A cet effet le capteur optoélectronique de déplacement longitudinal objet de l'invention, est caractérisé en ce qu'il comporte des moyens de filtrage et de protection contre les surtensions, des moyens d'émission et de réception de rayons infrarouges : des moyens de codage en code binaire réfléchi des signaux issus des moyens de réception des rayons infrarouges ; des moyens de transformation des signaux codés en code binaire réfléchi de manière qu'en sortie du capteur on dispose d'un nombre binaire ordinaire représentatif de la grandeur variable du déplacement.

La description qui va suivre en regard des dessins annexés fera mieux comprendre comment l'invention peut être réalisée.

La figure 1 est la représentation schématique du capteur objet de l'invention.

La figure 2 est une vue en perspective du capteur selon un mode préféré de réalisation.

La figure 3 est une vue de dessus de l'écran opaque mobile.

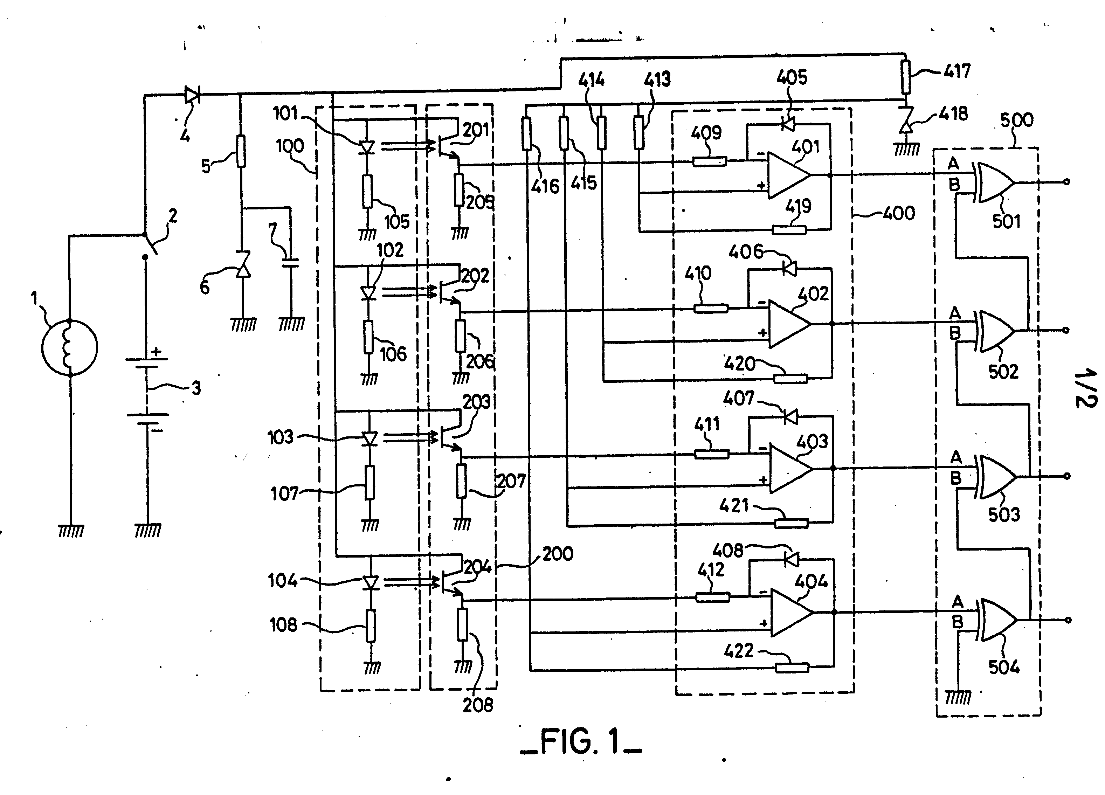

Le capteur optoélectronique selon l'invention et représenté schématiquement par la figure 1 comprend des moyens de filtrage et de protection contre les surtensions provenant de consommateurs selfiques,

tels que des moteurs ou solénoïdes connectés en parallèle au point commun de l'interrupteur 2 permettant l'alimentation du capteur à partir d'une source d'énergie 3, telle une batterie de bord de véhicule automobile, laquelle source d'énergie 3 alimente le capteur optoélectronique.

Les moyens de filtrage et protection sont constitués d'une diode 4 connectée dans son sens de conduction à la source d'énergie 3, par l'intermédiaire de l'interrupteur 2, d'une résistance 5 reliée par une de ses extrémités à la cathode de la diode 4 ; d'une diode zener 6 connectée d'une part à l'autre extrémité de la résistance 5 et d'autre part au pôle négatif du capteur ; d'un condensateur 7 relié d'une part à la cathode de la diode zener 6 et d'autre part au pôle négatif du capteur.

Les moyens d'émission 100 de rayons infrarouges sont constitués de photodiodes 101 à 104, de longueur onde moyenne 940 manomètre, connectées en parallèle par leurs anodes respectives à la cathode de la diode 4 et par leurs cathodes respectives au pôle négatif du capteur par l'intermédiaire de résistances 105 à 108.

Les moyens de réception 200 des rayons infrarouges émis par les photodiodes 101 à 104 sont constitués de phototransistors 201 à 204 connectés respectivement par chacun de leurs collecteurs à l'anode de leur photodiode associée, chacun des émetteurs des phototransitors étant relié au pôle négatif du capteur par l'intermédiaire d'une résistance 205 à 208.

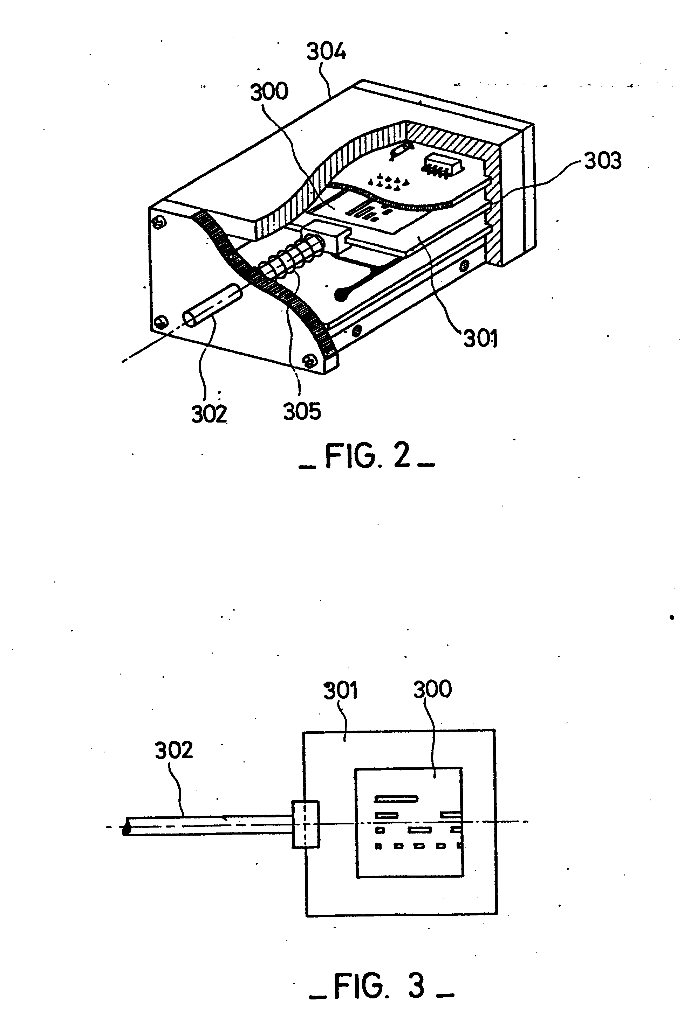

Le moyen d'occultation de l'émission de rayons infrarouges est constitué d'un écran opaque 300 (voir figure 3) muni de zones transparentes obtenues par le procédé d'impression d'un film photographique, lesquelles zones sont de dimensions, de formes et de répartition telles qu'en fonction du déplacement dudit écran on assure l'occultation séquencé de l'émission de rayons infrarouges.

L'écran opaque 300 est fixé par collage, rivetage, ou pinçage, sur un support 301 ajouré à l'endroit des ouvertures de l'écran opaque, lequel support 301 muni d'un élément de traction 302 coulisse dans des rainures 303 prévues, à cet effet, dans le corps 304 du capteur (voir fig. 2).

Un ressort de compression 305 assure le positionnement de l'écran lorque celui-ci n'est soumis à aucune sollicitation de déplacement.

L'élément de traction 302 est connecté à un organe mobile, tel par exemple qu'un papillon de carburateur, de façon que les variations de position dudit papillon assurent le déplacement du support 301 de l'écran 300 et que par occultation séquentielle de l'émission de rayons infrarouges on obtienne à l'émetteur des phototransistors 201 à 204 une tension variant de façon continue entre zéro volt et la valeur de la tension d'alimentation.

Les moyens de codage 400 en code binaire réfléchi sont constitués d'amplificateurs opérationnels 401 à 404, montés en comparateurs (voir fig. 1). Les tensions de comparaison sont obtenues par des diodes 405 à 408 connectées dans leurs sens de conduction entre la sortie et l'entrée inverseuse (-) des amplificateurs.

Les entrées inverseuses (-) des amplificateurs opérationnels sont connectées respectivement, par l'intermédiaire de résistances 409 à 412 aux émetteurs des phototransistors associés 201 à 204.

Les entrées directes (+) des amplificateurs opérationnels sont reliées respectivement, par l'intermédiaire de résistances 413 à 416 à la sortie d'une alimentation stabilisée constituée de façon connue d'une résistance 417 et d'une diode zener 418.

Les entrées directes (+) des amplificateurs opérationnels sont également reliées respectivement à la sortie desdits amplificateurs par l'intermédiaire de résistances 419 à 422, qui en coopération avec les résistances 413 et 416 procurent un effet d'hystérésis tel que la tension de sortie des amplificateurs opérationnels changera d'état lorsqu'il y aura égalité des tensions d'entrée.

Lorsque la tension sur l'entrée inverseuse (-) diminue, la tension de sortie devient égale à 5 volts dans cet exemple de réalisation, et revient à zéro lorsque la tension de l'entrée inverseuse (-) augmente.

On dispose donc en sortie des amplificateurs opérationnels d'une information d'un code binaire réfléchi dit "code de Gray" dont on sait que l'avantage est le passage d'une position à une autre en changeant un seul bit, ce qui élimine les risques d'erreurs.

Pour utiliser ce circuit à l'entrée d'un système de décodage logique TTL la tension de sortie doit être limitée à 5 volts.

Les diodes 405 à 408 connectées entre les sorties et les entrées inverseuses (-) dont la chute de tension est de 0,6 volt procurent ainsi une tension de comparaison de 4,4 volts d'où une tension de sortie de 5 volts. Le fait de ramener la tension à 4,4 volts à l'entrée inverseuse (-) impose d'avoir une valeur de résistance élevée (56KΩ) pour les résistances 409 à 412 de manière à ne pas avoir d'effet gênant sur les émetteurs des phototransistors associés.

Les moyens de transformation 500 en code binaire ordinaire des signaux codés en code binaire réfléchi sont constitués d'opérateurs logiques TTL "OU exclusif" 501 à 504 dont les entrées A sont reliées (voir figure 1) respectivement aux sorties des amplifica - teurs opérationnels qui leurs sont associés. Les entrées B des portes "OU exclusif", moins la sortie de la porte 504 reliée au pôle négatif du capteur, sont connectées en cascade à la sortie desdites portes de manière que l'on dispose en sortie d'un nombre binaire ordinaire représentatif de la grandeur variable du déplacement.

Dans l'exemple non exclusif d'application à la mesure de la variation de déplacement, le capteur optoélectronique, objet de l'invention, comporte 4 bits de sortie, et la course a été divisée en seize zones correspondant chacune à une plage de 5,6° de manière à mesurer un déplacement de 90° du papillon d'un carburateur.

Il est évident que le nombre de composants du capteur optoélectronique, objet de l'invention, peut être augmenté de la quantité nécessaire à l'obtention de la précision requise pour une autre application.

Dans le mode de réalisation particulier de l'invention, les composants utilisés sont les suivants :

REPERES

     4

     405

     406  Diode 1 N 4148

     407

     408

     5 - Résistance 470 Ω

     6 - Diode zener BPX 850-27V

     7 - Condensateur tantale 4,7 microfarad

     100 - Photodiodes LD 264 - Siemens

  105 à 108 - Résistances 1,8 K Ω

200 - Phototransistors BPX 84 - Siemens

205 à 208 - Résistances 18 KΩ

401 à 404 - Circuit SN 2902 - National Semiconducteurs

409 à 412 - Résistances 56 KΩ

418 à 416 - Résistances 1 KΩ

417 - Résistances 2,2KΩ

418 - Diode zener 4,7 V

419 à 422 - Résistances 100 KΩ

501 à 504 - Circuit SN 2902 Texas

- 6 -

Revendications        -

1.- Capteur optoélectronique de déplacement longitudinal, caractérisé en ce qu'il comporte des moyens de filtrage et de protection
contre les surtensions : des moyens d'emission et de réception de
rayons infrarouges, : un moyen d'occultation de l'emission de rayons infrarouges : des moyens de codage en code binaire réfléchi
des signaux issus des moyens de réception des rayons infrarouges :
des moyens de transformation des signaux codés en code binaire réfléchi de manière qu'en sortie du capteur on dispose d'un nombre
binaire ordinaire représentatif de la grandeur variable du déplacement.

2.- Capteur optoélectronique suivant la revendication 1, caractérisé en ce que les moyens de filtrage et de protection contre les
surtensions sont constitués d'une diode 4 connectée dans son sens
de conduction à la source d'énergie, par l'intermédiaire d'un
interrupteur ;d'une résistance 5 reliée par une de ses extrémités
à la cathode de la diode 4 ; d'une diode zener 6 connectée d'une
part à l'autre extrémité de la résistance 5, et d'autre part au
pôle négatif du capteur ; d'un condensateur 7 relié d'une part à
la cathode de la diode zener 6 et d'autre part au pôle négatif du
capteur.

3.- Capteur optoélectronique suivant la revendication 1, caractéris
en ce que les moyens d'emission des rayons infrarouges sont constitués d'une pluralité de photodiodes 101 à 104 connectées én parallè
le par leurs anodes respectives à la cathode de la diode 4 et par
leurs cathodes respectives au pôle négatif du capteur par l'intermédiaire d'une pluralité de résistances 105 à 108 et en ce que les
moyens de réception sont constitués d'une pluralité de phototransistors 201 à 204 connectés respectivement par chacun de leurs col·
lecteurs à l'anode de leur photodiode associée, chacun des emetteurs des phototransistors étant relié au pôle négatif du capteur
par l'intermédiaire d'une résistance 205 à 208.

4.- Capteur optoélectronique suivant la revendication 1, caractéri
sé en ce que le moyen d'occultation de l'émission de rayons infrarouges est constitué d'un écran opaque 300 muni d'ouvertures trans
parentes de dimensions, de formes et de répartition telle qu'en fonction du déplacement dudit écran on obtienne à l'émetteur des phototransistors 201 à 204 une tension variant de façon continue entre zéro volt et la valeur de la tension d'alimentation.

5.- Capteur optoélectronique suivant la revendication 1, caractérisé en ce que les moyens de codage en code binaire réfléchi sont constitués d'une pluralité d'amplificateurs opérationnels 401 à 404, montés en comparateurs, dont les entrées inverseuses (-) sont connectées respectivement, par l'intermédiaire de résistances 409 à 412 aux émetteurs de phototransistors associés 201 à 204, les entrées directes (+) des amplificateurs opérationnels sont reliées respectivement par l'intermédiaire de résistances 413 à 416 à la sortie de l'alimentation stabilisée d'une part et d'autre part, à la sortie des amplificateurs opérationnels par l'intermédiaire de résistances 419 à 422, lesquelles sorties sont reliées, à leurs entrées inverseuses respectives, par l'intermédiaire de diodes 405 à 408 connectées dans leur sens de conduction entre la sortie et l'entrée inverseuse de manière à disposer d'une tension de sortie apte à assurer le fonctionnement des moyens de décodage.

6.- Capteur optoélectronique suivant la revendication 1, caractérisé en ce que les moyens de transformation en code binaire ordinaire, des signaux codés en code binaire réfléchi sont constitués d'une pluralité d'opérateurs logiques "OU exclusif" 501 à 504 dont les entrées A sont reliées respectivement aux sorties des amplificateurs opérationnels qui leurs sont associés et dont les entrées B, moins une reliée au pôle négatif du capteur, sont connectées en cascade à la sortie des opérateurs logiques de manière que l'on dispose en sortie d'un nombre binaire ordinaire représentatif de la grandeur variable du déplacement.

_FIG. 1_

1/2

0007267

304

300

303

301

302  305

_ FIG. 2 _

301  300

302

_ FIG. 3 _

0007267

| Catégorie | Citation du document avec indication, en cas de besoin, des parties pertinentes | Revendication concernée | CLASSEMENT DE LA DEMANDE (Int. Cl. ¹) |
|---|---|---|---|
| | **DOCUMENTS CONSIDERES COMME PERTINENTS** | | |
| | US - A - 3 888 118 (NIMS)<br>* Abrégé; figure 7; colonne 9, lignes 31-43 * | 1,4 | G 01 D 5/34<br>H 03 K 13/18 |
| | US - A - 3 824 587 (FOWLER)<br>* Abrégé; figures 1,3; colonne 2, lignes 20-68 * | 1,4,6 | |
| | FR - A - 1 354 422 (CFT-H)<br>* Figures 4,15; page 4, colonne 1, lignes 24-38 * | 1,2,4 | **DOMAINES TECHNIQUES RECHERCHES (Int. Cl. ³)** |
| | US - A - 2 758 788 (JAEGER)<br>* Colonne 2, ligne 34 - colonne 3, ligne 9 * | 1,4,6 | G 01 D 5/32<br>G 01 D 5/34<br>G 01 D 5/40<br>H 03 K 13/18<br>G 06 G 7/25<br>H 03 K 3/02<br>G 01 R 19/16 |
| A | US - A - 3 742 233 (GORGENS et al)<br>* Abrégé; figures 1A,1B; colonne 3, lignes 12-22 * | 1,4 | |
| A | IEEE SPECTRUM, June 1971, pages 38-46<br>New York USA<br>J.R. NAYLOR: "Digital and Analog Signal Applications of Operational Amplifies"<br>* Figures 30,32 * | 5 | **CATEGORIE DES DOCUMENTS CITES**<br>X: particulièrement pertinent<br>A: arrière-plan technologique<br>O: divulgation non-écrite<br>P: document intercalaire<br>T: théorie ou principe à la base de l'invention<br>E: demande faisant interférence<br>D: document cité dans la demande<br>L: document cité pour d'autres raisons<br>&: membre de la même famille, document correspondant |

Le présent rapport de recherche a été établi pour toutes les revendications

| Lieu de la recherche | Date d'achèvement de la recherche | Examinateur |
|---|---|---|
| La Haye | 12-10-1979 | LLOYD |

OEB Form 1503.1   06.78